# EUROPEAN PATENT SPECIFICATION

(11) **EP 2 168 160 B1**
(45) Date of publication and mention of the grant of the patent: **10.01.2018**
(21) Application number: 08775108.7
(22) Date of filing: 16.07.2008
(51) Int. Cl.: H01L 23/29, H01L 23/31, H01L 25/07

(54) **SEMICONDUCTOR MODULE**
HALBLEITERMODUL
MODULE SEMI-CONDUCTEUR

(30) Priority: 20.07.2007 EP 07112854
(43) Date of publication of application: 31.03.2010
(73) Proprietor: ABB Schweiz AG, 5400 Baden (CH)
(72) Inventor: TRÜSSEL, Dominik, 5620 Bremgarten (CH); SCHNEIDER, Daniel, 5454-Bellikon (CH)
(74) Representative: ABB Patent Attorneys
(86) International application number: PCT/EP2008/059258
(87) International publication number: WO 2009/013186

(56) References cited:
- DE-A1- 10 123 232
- FR-A- 2 518 812
- JP-A- 10 233 472
- US-A- 5 977 621
- US-A1- 2003 089 974

## Description

### Technical Field

The invention relates to the field of power electronics and more particularly to a semiconductor module according to the preamble of claim 1.

### Background Art

Semiconductor modules for high power application can comprise a housing and semiconductor chips sealed inside the housing. The housing has side walls and it is closed on one side of the side walls by a base plate, on which the semiconductor chips are arranged, and on the opposite side with a lid. In the housing, electrically insulating silicone gel filler is inserted, thus covering the chips. The lid together with the packaging resin seals the housing from the top. Typically, electrical terminals for electrically contacting the chips are soldered on the base plate. The terminals lead from the base plate through the gel, the hardened resin and the lid.
For manufacturing, the gel is filled into the housing at room temperature and is cured at enhanced temperature, typically about 125 °C. On the gel filler a packaging resin is filled and cured. The resin is also cured at enhanced temperature, typically also at 125 °C. Therefore, the gel is thermally expanded when filling in the resin and it shrinks when the module cools down. As the gel sticks to the resin, cracks emerge in the gel. These cracks can lead to partial discharge, thereby damaging or even destroying the module. US 2003/089974 A1 discloses a semiconductor module comprising a gel filled in a casing. JP 10-233472 shows a semiconductor device with means to reduce such cracks. Also, this module comprises a housing with side walls closed on one side of the side walls by a base plate and on the opposite side with a lid. On the base plate semiconductor chips are arranged. In the housing, silicone gel filler is inserted, thus covering the chips. On the gel filler a packaging resin is filled and cured. The lid together with the packaging resin seals the housing from the top. The housing has an L-shaped projection extending from the side walls into the housing, the projection being open to the gel filler, thus forming a space within the housing which is completely sealed against the surrounding. If the gel is expanded due to heat, over pressure is produced in the air-filled space by the expanding gel and the gel presses against the lid and the packaging resin.

### Disclosure of Invention

It is an object of the invention to provide a power semiconductor module with a case filled with a gel layer and above of it, with a hardened resin, in which cracks in the gel due to thermal expansion are avoided.
This object is achieved by a semiconductor module according to claim 1.
The semiconductor module comprises a base plate, at least one semiconductor chip mounted on the base plate, a case fixed to the base plate and surrounds the at least one semiconductor chip, an electrically insulating gel layer covering the at least one semiconductor chip, a thermosetting resin layer on top of gel layer and a lid on top of the thermosetting resin layer. The lid comprises a lid-opening, which defines a lid-opening, which extends through the thermosetting resin layer to the gel layer and by which lid-opening (71) the gel can expand.
By having a lid with such a lid-opening the gel can expand in case of heat within the lid-opening so that the gel can expand more easily. In not sealed gas-tight to the surrounding there is no vacuum or over-pressure in the volume defined by the lid-opening, thereby allowing more easily pressure compensation.
Further preferred embodiments of the inventive subject matter are disclosed in the dependent claims.

### Brief Description of Drawings

The subject matter of the invention will be explained in more detail in the following text with reference to the attached drawings, in which:
- FIG 1: shows a cross sectional view on semiconductor module according to the invention;
- FIG 2: shows a cross sectional view on another embodiment of semiconductor module according to the invention; and
- FIG 3: shows a cross sectional view on another embodiment of semiconductor module according to the invention.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

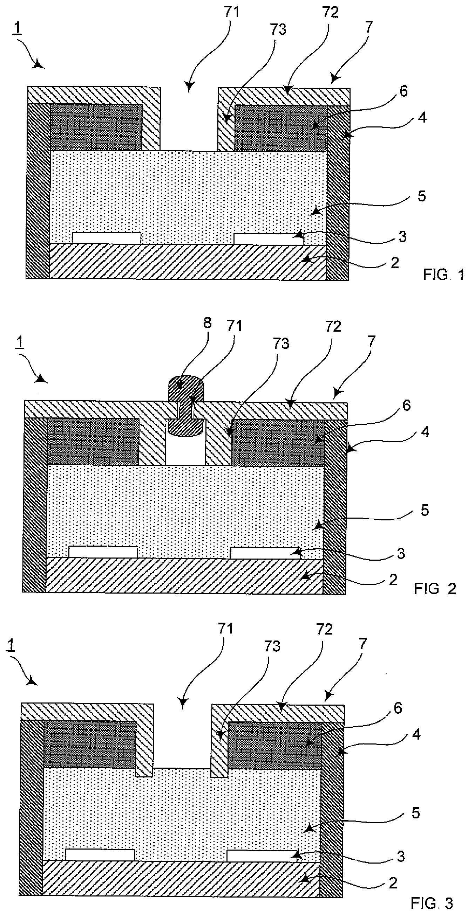

As shown in fig. 1 the semiconductor module 1 according to the invention comprises a base plate 2, at least one semiconductor chip 3 mounted on the base plate 2, a case 4 fixed to the base plate 2 and surrounds the at least one semiconductor chip 3, an electrically insulating gel layer 5 covering the at least one semiconductor chip 3, a thermosetting resin layer 6 on top of gel layer 5 and a lid 7 on top of the thermosetting resin layer 6. Preferably, the material of the gel layer 5 is a silicone gel. The material of the thermosetting resin layer 6 is in particular an epoxy resin.

The lid 7 has a lid-extension 73, which defines a lid-opening 71, which extends through the thermosetting resin layer 6 to the gel layer 5 and by which lid-opening 71 the gel can extend.

In a preferred embodiment the lid-opening 71 allows gas convection, i.e. the lid-opening 71 is open to the environment so that the pressure within the lid-opening 71 is balanced, i.e. the same as in the environment at any time and gas can pass the lid 7.

In another preferred embodiment, the lid opening 71 lies within an area, which is located outside the orthogonal projection of the area in which the at least one chip 3 is located. This location is advantageous, because in case of an explosion, which typically originates in the chips, the thermosetting resin layer 6 and the lid 7 prevent that the explosion is directed vertically to the base. Instead the energy is absorbed by the thermosetting resin layer 6 and the lid 7 protecting people or other equipment in the vicinity of the module.

Preferably, as shown in fig. 2 the lid opening 71 is closed by a cover 8, especially by a rivet, which allows gas to pass the cover 8 to compensate a change of gas pressure due to a temperature change in the module so that pressure within the lid opening 71 under the cover 8 and above the thermosetting resin layer 6 is balanced with the environment pressure. Such a cover 8 prevents dust or other undesired particles to enter the module 1, and avoids under- or overpressure in case of a temperature rise or sinking. The rivet is made of plastics or any other electrically insulating material. In order to have easy manufacturing the rivet can be made as a blind rivet, which can be mounted from the outer side of the module. One-piece blind rivets, such as rivet plugs or slit rivets, as well as two-piece blind rivets, such a two-piece slit rivets, are suitable.

In another preferred embodiment shown in fig. 3, the lid extension 73 extends into the gel layer 5. This makes the manufacturing of the module easier, because less mechanical accuracy is required. During manufacturing after incurring of the gel at enhanced temperature the gel cools down and therefore, sags within the lid opening 71. The lid extension 73 extending into the gel layer 5 ensures that the thermosetting resin, when filled in after having cooled down the gel, cannot flow into the lid opening 71 even if the gel has sagged.

## Claims

1. Semiconductor module (1) comprising
a base plate (2),
at least one semiconductor chip (3) mounted on the base plate (2),
a case (4) fixed to the base plate (2) and surrounding the at least one semiconductor chip (3),
an electrically insulating gel layer (5) covering the at least one semiconductor chip (3),
a thermosetting resin layer (6) on top of the gel layer (5), a lid (7) on top of the thermosetting resin layer (6),
**characterized in that**
the lid (7) comprises a lid-extension (73), which defines a lid-opening (71), which extends through the thermosetting resin layer (6) to the gel layer (5) and by which lid-opening (71) the gel can expand.

2. Semiconductor module (1) according to claim 1, wherein
the material of the gel layer (5) is a silicone gel and/or the material of
the thermosetting resin layer (6) is an epoxy resin.

3. Semiconductor module (1) according to claim 1 or 2, wherein
the lid-extension (73) extends into the gel layer (5).

4. Semiconductor module (1) according to any of the claims 1 to 3,
wherein
the lid-opening (71) lies within an area, which is located outside the orthogonal projection of the area in which the at least one chip (3) is located.

5. Semiconductor module (1) according to any of the claims 1 to 4,
wherein
the lid-opening (71) is open to the environment.

6. Semiconductor module (1) according to any of the claims 1 to 4,
wherein
the lid-opening (71) is closed by a cover (8).

7. Semiconductor module (1) according to claim 6, wherein
the cover (8) is a rivet.

8. Semiconductor module (1) according to claim 7, wherein
the rivet is a blind rivet, especially a one-piece or a two-piece blind rivet.

9. Semiconductor module (1) according to claim 7 or 8, wherein
the rivet is made of electrically insulating material, especially of plastics.

10. Semiconductor module (1) according to any of the claims 6 to 9,
wherein the cover (8) is such that gas can pass the lid-opening (71) to compensate a change of pressure due to a temperature change in the module.

11. Semiconductor module (1) according to any of the claims 1 to 10,
wherein
the lid opening (71) lies within an area, which is located outside the orthogonal projection of the area in which the at least one chip (3) is located.

## Patentansprüche

1. Halbleitermodul (1), umfassend
eine Grundplatte (2),
wenigstens einen auf der Grundplatte (2) montierten Halbleiterchip (3),
ein an der Grundplatte (2) festgelegtes und den
wenigstens einen Halbleiterchip (3) umgebendes Gehäuse (4),
eine den wenigstens einen Halbleiterchip (3) bedeckende, elektrisch isolierende Gelschicht (5),
eine warmhärtende Harzschicht (6) auf der Gelschicht (5),
einen Deckel (7) auf der warmhärtenden Harzschicht (6), **dadurch gekennzeichnet, dass** der Deckel (7) eine Deckelerweiterung (73) umfasst, die eine Deckelöffnung (71) bildet, welche sich durch die warmhärtende Harzschicht (6) zur Gelschicht (5) erstreckt, und durch welche Deckelöffnung (71) sich das Gel ausdehnen kann.

2. Halbleitermodul (1) gemäß Anspruch 1, wobei das Material der Gelschicht (5) ein Silikongel ist und/oder das Material der warmhärtenden Harzschicht (6) ein Epoxidharz ist.

3. Halbleitermodul (1) gemäß Anspruch 1 oder 2, wobei sich die Deckelerweiterung (73) in die Gelschicht (5) erstreckt.

4. Halbleitermodul (1) gemäß einem der Ansprüche 1 bis 3, wobei die Deckelöffnung (71) innerhalb eines Bereiches liegt, der außerhalb der orthogonalen Projektion des Bereiches liegt, in welchem sich der wenigstens eine Chip (3) befindet.

5. Halbleitermodul (1) gemäß einem der Ansprüche 1 bis 4, wobei die Deckelöffnung (71) zur Umgebung hin offen ist.

6. Halbleitermodul (1) gemäß einem der Ansprüche 1 bis 4, wobei die Deckelöffnung (71) von einer Abdeckung (8) verschlossen ist.

7. Halbleitermodul (1) gemäß Anspruch 6, wobei die Abdeckung (8) eine Niete ist.

8. Halbleitermodul (1) gemäß Anspruch 7, wobei die Niete eine Blindniete, insbesondere eine einteilige oder eine zweiteilige Blindniete ist.

9. Halbleitermodul (1) gemäß Anspruch 7 oder 8, wobei die Niete aus elektrisch isolierendem Material, insbesondere aus Kunststoff, hergestellt ist.

10. Halbleitermodul (1) gemäß einem der Ansprüche 6 bis 9, wobei die Abdeckung (8) so beschaffen ist, dass Gas durch die Deckelöffnung (71) hindurchtreten kann, um eine Druckänderung aufgrund einer Temperaturänderung im Modul auszugleichen.

11. Halbleitermodul (1) gemäß einem der Ansprüche 1 bis 10, wobei die Deckelöffnung (71) innerhalb eines Bereiches liegt, der sich außerhalb der orthogonalen Projektion des Bereiches befindet, in welchem sich der wenigstens eine Chip (3) befindet.

## Revendications

1. Module semi-conducteur (1) comprenant
une plaque de base (2),
au moins une puce semi-conductrice (3) montée sur la plaque de base (2),
un boîtier (4) fixé à la plaque de base (2) et entourant l'au moins une puce semi-conductrice (3),
une couche de gel électriquement isolant (5) recouvrant l'au moins une puce semi-conductrice (3),
une couche de résine thermodurcissable (6) au-dessus de la couche de gel (5),
un capot (7) au-dessus de la couche de résine thermodurcissable (6),
**caractérisé en ce que**
le capot (7) comprend une extension de capot (73), qui définit une ouverture de capot (71), qui s'étend à travers la couche de résine thermodurcissable (6) jusqu'à la couche de gel (5), et ouverture de capot (71) par laquelle le gel peut se dilater.

2. Module semi-conducteur (1) selon la revendication 1, dans lequel
le matériau de la couche de gel (5) est un gel de silicone et/ou le matériau de la couche de résine thermodurcissable (6) est une résine époxy.

3. Module semi-conducteur (1) selon la revendication 1 ou 2, dans lequel
l'extension de capot (73) s'étend à l'intérieur de la couche de gel (5).

4. Module semi-conducteur (1) selon l'une quelconque des revendications 1 à 3, dans lequel
l'ouverture de capot (71) se trouve à l'intérieur d'une zone qui est située à l'extérieur de la projection orthogonale de la zone dans laquelle est située l'au moins une puce (3).

5. Module semi-conducteur (1) selon l'une quelconque des revendications 1 à 4, dans lequel
l'ouverture de capot (71) est ouverte sur l'environnement.

6. Module semi-conducteur (1) selon l'une quelconque des revendications 1 à 4, dans lequel
l'ouverture de capot (71) est fermée par un couvercle (8).

7. Module semi-conducteur (1) selon la revendication 6, dans lequel
le couvercle (8) est un rivet.

8. Module semi-conducteur (1) selon la revendication 7, dans lequel
le rivet est un rivet aveugle, en particulier un rivet aveugle monobloc ou en deux parties.

9. Module semi-conducteur (1) selon la revendication 7 ou 8, dans lequel
le rivet est constitué d'un matériau électriquement isolant, en particulier de matière plastique.

10. Module semi-conducteur (1) selon l'une quelconque des revendications 6 à 9, dans lequel
le couvercle (8) est tel que le gaz peut passer par l'ouverture de capot (71) pour compenser un changement de pression dû à un changement de température dans le module.

11. Module semi-conducteur (1) selon l'une quelconque des revendications 1 à 10, dans lequel
l'ouverture de capot (71) se trouve à l'intérieur d'une zone qui est située à l'extérieur de la projection orthogonale de la zone dans laquelle est située l'au moins une puce (3).
